# EUROPEAN PATENT APPLICATION

(11) **EP 4 682 629 A1**
(43) Date of publication of application: **21.01.2026**
(21) Application number: 23928330.2
(22) Date of filing: 24.10.2023
(51) Int. Cl.: G03B 21/16

(54) **HEAT DISSIPATION ASSEMBLY AND PROJECTION APPARATUS**

(30) Priority: 17.03.2023 CN 202320551303 U
(71) Applicant: Shenzhen Roborock Innovation Technology Co., Ltd., Shenzhen, Guangdong 518000 (CN); Beijing Roborock Technology Co., Ltd., Beijing 102206 (CN)
(72) Inventor: ZHANG, Wei, Beijing 102206 (CN); WANG, Mingchuan, Beijing 102206 (CN)
(74) Representative: Lorenz Seidler Gossel Part. mbB
(86) International application number: PCT/CN2023/126232
(87) International publication number: WO 2024/193026

(57) **Abstract**

A heat dissipation assembly and a projection apparatus. The heat dissipation assembly comprises a TEC (1) and a first heat dissipation component (3), wherein one end of the TEC (1) comprises a cold surface, and the other end thereof comprises a hot surface; the hot surface of the TEC (1) fits with the first heat dissipation component (3); the cold surface of the TEC (1) fits with an assembly to be subjected to heat dissipation; and an edge of the cold surface of the TEC (1) is coated with a heat-insulating sealing layer, so as to perform sealing and heat insulation on the end of the TEC (1) comprising the cold surface. In this way, only the cold end is sealed, and the hot end of the TEC (1) is not sealed, such that the heat dissipation effect and the heat dissipation efficiency of the hot end are improved, the effect of heat generated at the hot end on the temperature of the cold end is reduced, and the material used for a sealing member of the TEC (1) is also reduced, thereby reducing the cost.

## Description

### CROSS-REFERENCE TO RELATED APPLICATIONS

The present disclosure claims priority to the Chinese patent application No. 202320551303.7, entitled "HEAT DISSIPATION ASSEMBLY AND PROJECTION DEVICE" and filed on March 17, 2023, which is incorporated herein by reference in its entirety.

### TECHNICAL FIELD

The present disclosure relates to the field of heat dissipation technologies, and in particular to a heat dissipation assembly and a projection device.

### BACKGROUND

With the improvement of science and technology, an increasing number of highly integrated and highly precise electronic devices, such as projection devices, are developed and used. In a use process of the projection device, a light source assembly will generate a lot of heat, leading to a rapid increase in the temperature of the light source assembly, and the higher temperature will seriously affect the performance and reliability of the light source assembly. In order to reduce the temperature, a TEC (thermal electronic cooler) is usually mounted in the projection device to cool the light source assembly.

At present, the TEC is sandwiched between a heat dissipation plate and the light source assembly, a cold surface of the TEC is in contact with the light source assembly, a hot surface of the TEC is in contact with the heat dissipation plate, and a sealing member sleeves the TEC, so as to place the whole TEC in a sealed cavity defined by the heat dissipation plate, the light source assembly and the sealing member, thereby achieving the sealing between the cold surface of the TEC and the light source assembly. However, heat generated by the hot surface of the TEC is difficultly dissipated from the sealed cavity and will lead to the temperature rise of the cold surface of the TEC, which reduces the heat dissipation efficiency of the cold surface of the TEC and negatively affects a heat dissipation effect of the cold surface of the TEC. In addition, by positioning and mounting the TEC through a cavity in the sealing member, the size mismatch between the TEC and the cavity easily occurs and causes the inclination of the TEC easily, which leads to the damage to a ceramic surface due to an excessive pressure on part of the TEC when the TEC and the cold surface are mounted and further reduces the production yield. In order to avoid the above situation, it is necessary to improve the machining accuracy of the cavity, causing low production efficiency.

### SUMMARY

A series of simplified concepts are introduced in the Summary section of the present invention, and will be further explained in detail in the Detailed Description Section. The Summary section of the present disclosure does not mean to attempt to define the key features and necessary technical features of the claimed technical solutions, let alone to determine the protection scope of the claimed technical solutions.

In a first aspect, an embodiment of the present disclosure provides a heat dissipation assembly including a TEC and a first heat dissipation component;

one end of the TEC includes a cold surface, and the other end of the TEC includes a hot surface; the hot surface of the TEC is attached to the first heat dissipation component, and the cold surface of the TEC is attached to an assembly to be subjected to heat dissipation; a heat-insulation sealing layer is arranged on an edge of the cold surface of the TEC to seal and thermally insulate on one end of the TEC including the cold surface.

Optionally, the heat-insulation sealing layer includes a heat-insulation sealing ring formed by heat insulation sealant, and the heat-insulation sealing ring is used to seal and thermally insulate one end of the TEC including the cold surface.

Optionally, at least part of area of a surface, attached to the cold surface of the TEC, on the assembly to be subjected to heat dissipation is provided with a heat insulation layer.

Optionally, a first heat-conduction layer is arranged between the hot surface of the TEC and the first heat dissipation component.

Optionally, a second heat-conduction layer is arranged between the cold surface of the TEC and the assembly to be subjected to heat dissipation.

Optionally, the first heat dissipation component is provided with a first connecting component for being connected with an encapsulation shell; and the assembly to be subjected to heat dissipation is provided with a second connecting component for being connected with the encapsulation shell.

Optionally, a side of the first heat dissipation component away from the TEC is further provided with a second heat dissipation component.

Optionally, the second heat dissipation component includes heat dissipation tubes and/or heat dissipation fins.

Optionally, the assembly to be subjected to heat dissipation includes a light source back plate, light sources of a projection device are mounted on one side of the light source back plate, and the other side of the light source back plate is attached to the cold surface of the TEC.

Optionally, the first heat dissipation component and the light source back plate are both metal plates.

Optionally, a portion of the light source back plate in contact with air is provided with a heat insulation layer, and the heat insulation layer is used for reducing heat transferred from outside hot air to the light source back plate.

Optionally, the light sources include a plurality of projection lamps, at least two projection lamps of all the light sources emit light of different colors, and a TEC heatsink is arranged nearby the projection lamp emitting light of a preset color.

In a second aspect, an embodiment of the present disclosure provides a projection device, including an encapsulation shell, and the encapsulation shell is provided with an assembly to be subjected to heat dissipation and the above heat dissipation assembly.

For the heat dissipation assembly and the projection device according to the embodiments of the present disclosure, only one end of the TEC including the cold surface is provided with the heat-insulation sealing layer, so that only the cold end is sealed, and the hot end of the TEC is not sealed. In this way, the hot end of the TEC can still be in contact with the outside air for heat dissipation through convection, so that a heat dissipation effect and heat dissipation efficiency of the hot end are improved, and the influence of heat generated by the hot end on the temperature of the cold end is also reduced. This enables the cold end to still maintain higher heat dissipation efficiency, ensures that the cold end still has a better heat dissipation effect, and also reduces material consumption of a sealing member of the TEC, thereby reducing the cost, and also avoiding the situation that as the TEC 1 is inclined in the cavity due to a larger error of the cavity formed in the sealing member, the TEC 1 is damaged due to excessive pressure on part of the TEC when the cold surface of the TEC is attached to the assembly to be subjected to heat dissipation. Therefore, the production yield is improved and easy implementation is achieved, and the requirement on process precision is also reduced, thereby greatly improving the production efficiency and reducing the production cost. In addition, the heat-insulation sealing layer can not only isolate the cold end of the TEC from ambient air, but also play a role of heat insulation, thereby reducing the heat transferred from the outside hot air to the cold end of the TEC, further greatly reducing or even eliminating the amount of condensed water generated when the outside hot air meets the low-temperature cold end, and avoiding the damage to the assembly to be subjected to heat dissipation and surrounding elements thereof caused by moisture due to a large amount of condensed water.

### BRIEF DESCRIPTION OF THE DRAWINGS

The following accompanying drawings of the present disclosure, as part of embodiments of the present disclosure, are used for understanding the present disclosure. The embodiments of the present disclosure and their descriptions are shown in the accompanying drawings to explain principles of the present disclosure.

In the accompanying drawings:

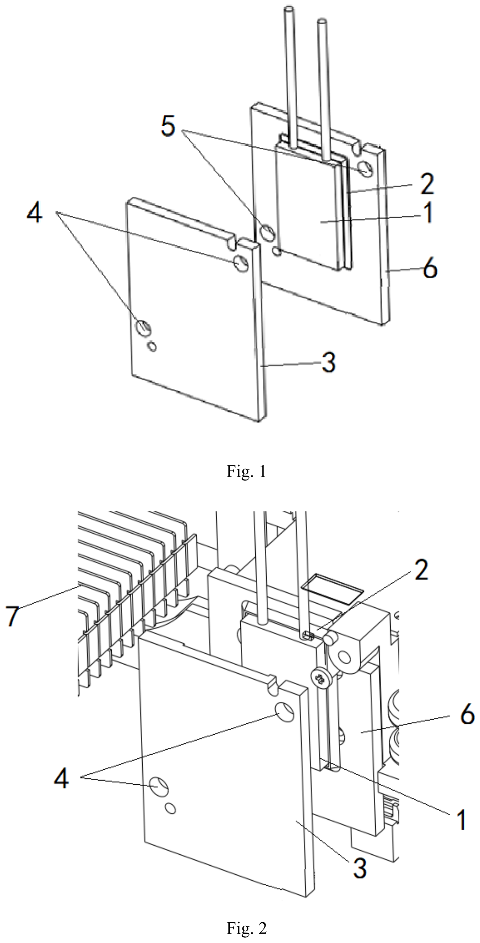

Fig. 1 is a structural diagram of a heat dissipation assembly according to an optional embodiment of the present disclosure; and
Fig. 2 is a diagram of an application scenario of a heat dissipation assembly according to an optional embodiment of the present disclosure.

### Description of reference signs:

1-TEC, 2-heat-insulation sealing ring, 3-first heat dissipation component, 4-first connecting component, 5-second connecting component, 6-light source back plate, and 7-heat dissipation fin.

### DETAILED DESCRIPTION

In the following descriptions, a large number of specific details are given for more thorough understanding of the present disclosure. However, it is apparent for those skilled in the art that the present disclosure can be implemented without one or more of these details. In other examples, in order to avoid confusion with the present disclosure, some commonly known technical features in the art are not described.

It should be noted that the terms used here are only for describing specific embodiments, and not intended to limit the exemplary embodiments according to the present disclosure. As used herein, the singular form is also intended to include the plural form unless the context clearly indicates otherwise. Furthermore, it should also be understood that when the terms "include" and/or "comprise" are used in the description, they specify the presence of features, integers, steps, operations, elements and/or assemblies, but do not exclude the presence or addition of one or more other features, integers, steps, operations, elements, assemblies and/or their combinations.

Now, the exemplary embodiments according to the present disclosure will be described in more detail with reference to the accompanying drawings. However, these exemplary embodiments may be implemented in many different forms and should not be construed as limited to the embodiments set forth herein. It should be understood that these embodiments are provided for thorough and complete disclosure of the present disclosure, and fully conveying the concepts of these exemplary embodiments to those of ordinary skill in the art.

In a first aspect, an embodiment of the present disclosure provides a heat dissipation assembly, including a TEC 1 and a first heat dissipation component 3; one end of the TEC 1 includes a cold surface and the other end thereof includes a hot surface; and the hot surface of the TEC 1 is attached to the first heat dissipation component 3, and the cold surface of the TEC 1 is attached to an assembly to be subjected to heat dissipation. A heat-insulation sealing layer is arranged on an edge of the cold surface of the TEC 1 to seal and thermally insulate one end of the TEC including the cold surface.

In specific applications, the assembly to be subjected to heat dissipation may be an assembly generating more heat in an electronic device, such as a light source assembly of a projection device.

When the TEC 1 is powered on for working, a certain temperature difference will be forcibly formed between two ends of the TEC 1 due to the Peltier effect, so that one end of the TEC 1 includes the cold surface, that is, this end is a cold end; and the other end includes a hot surface, that is, this end is a hot end. The cold surface of the TEC 1 is attached to the assembly to be subjected to heat dissipation, and the hot surface is attached to the first heat dissipation component 3. In this way, the heat of the assembly to be subjected to heat dissipation is transferred to the cold surface of the TEC 1, so that the assembly to be subjected to heat dissipation is cooled by the cold surface of the TEC. Then the cold surface transfers the heat to the hot surface, and afterwards the heat of the hot surface is dissipated through the first heat dissipation component 3 to cool the hot surface, thereby improving the heat dissipation efficiency and a heat dissipation effect of the hot surface of the TEC, and thus an overall heat dissipation effect of the TEC 1. In addition, the cold surface of the TEC 1 is attached to the assembly to be subjected to heat dissipation, so that a heat transfer path between the cold surface and the assembly to be subjected to heat dissipation is shortened, thereby achieving the higher heat dissipation efficiency of the assembly to be subjected to heat dissipation. Similarly, the hot surface of the TEC 1 is attached to the first heat dissipation component 3, so that a heat transfer path between the hot surface and the first heat dissipation component 3 is shortened, thereby achieving higher heat dissipation efficiency of the hot surface.

Further, in the present disclosure, only the cold end of the TEC 1 is sealed, and the hot end of the TEC 1 is not sealed. In this way, the hot end of the TEC 1 can still be in contact with the outside air for heat dissipation through convection, so that the heat dissipation effect and the heat dissipation efficiency of the hot end are improved and the influence of heat generated by the hot end on the temperature of the cold end is reduced. This enables the cold end to still maintain higher heat dissipation efficiency, ensures that the cold end still has a better heat dissipation effect, and also reduces material consumption of a sealing member of the TEC 1, thereby reducing the cost, and also avoiding the situation that as the TEC 1 is inclined in the cavity due to a larger error of the cavity formed in the sealing member, the TEC 1 is damaged due to excessive pressure on part of the TEC when the cold surface of the TEC 1 is attached to the assembly to be subjected to heat dissipation. Therefore, the production yield is improved and easy implementation is achieved, and the requirement on process precision is also reduced, thereby greatly improving the production efficiency and reducing the production cost. In addition, the heat-insulation sealing layer can not only isolate the cold end of the TEC from ambient air, but also play a role of heat insulation, thereby reducing the heat transferred from outside hot air to the cold end of the TEC 1, further greatly reducing or even eliminating the amount of condensed water generated when the outside hot air meets the low-temperature cold end, and avoiding the damage to the assembly to be subjected to heat dissipation and surrounding elements thereof caused by moisture due to a large amount of condensed water.

Specifically, the heat-insulation sealing layer includes a heat-insulation sealing ring 2 formed by heat insulation sealant, and the heat-insulation sealing ring 2 is used to thermally insulate and seal on one end of the TEC 1 including the cold surface.

The heat insulation sealant may be a low-thermal-conductivity adhesive (such as silica gel or a UV adhesive). The heat-insulation sealing ring 2 may be formed by curing the heat insulation sealant. In a specific making process, after the cold surface is attached to the assembly to be subjected to heat dissipation, the edge of the cold surface may be coated with the heat insulation sealant by using an adhesive dispenser to thermally insulate and seal the cold end of the TEC.

The heat insulation sealant may also play a role of bonding and fixing, so that the TEC 1 can be stably connected with the assembly to be subjected to heat dissipation, and additional connecting components are also omitted, which not only reduces the cost, but also omits an assembly process of the connecting components, reduces workload of an operator and improves the working efficiency.

Further, at least part of area of the surface, attached to the cold surface of the TEC, on the assembly to be subjected to heat dissipation is provided with a heat insulation layer.

The heat insulation layer plays a role of isolating condensed water on the surface, attached to the cold surface of the TEC 1, on the assembly to be subjected to heat dissipation, which avoids the problem that water vapor in the air is condensed when meeting the low-temperature assembly to be subjected to heat dissipation, and solves the problem that the assembly to be subjected to heat dissipation and surrounding elements thereof are damaged by moisture due to the condensed water. Of course, the heat insulation layer needs to avoid the joint between the TEC and the assembly to be subjected to heat dissipation, so as to ensure the heat conduction efficiency of the TEC 1.

The heat insulation layer may be formed by solidifying the adhesive (such as silica gel or UV adhesive), which is convenient for making the heat insulation layer, and of course other heat insulation materials may also be used.

Further, a first heat-conduction layer is arranged between the hot surface of the TEC 1 and the first heat dissipation component 3.

The first heat-conduction layer may play a role of reducing thermal resistance, thereby increasing the speed at which the heat transferred from the hot surface to the first heat dissipation component 3, and thus achieving a better heat dissipation effect of the hot surface. The first heat-conduction layer may be a heat-conduction silicone grease layer, and the heat-conduction silicone grease has better heat conductivity, and simultaneously does not melt and flow at a high temperature and is odorless and non-toxic. Of course, the first heat-conduction layer may also be made of other substances with a heat conduction effect, which is not strictly limited by the present embodiment.

Further, a second heat conduction layer is arranged between the cold surface of the TEC 1 and the assembly to be subjected to heat dissipation.

The second heat-conduction layer may play a role of reducing the thermal resistance, thereby increasing the speed at which the heat transferred from the heat dissipation assembly to the cold surface, and achieving the better heat dissipation effect of the assembly to be subjected to heat dissipation. The second heat-conduction layer may be a heat conduction silicone grease layer, and the heat conduction silicone grease has better heat conductivity, and simultaneously does not melt and flow at a high temperature and is odorless and nontoxic. Of course, the first heat-conduction layer may also be made of other substances with a heat conduction effect, which is not strictly limited by the present embodiment.

Further, the first heat dissipation component 3 is provided with a first connecting component 4 for being connected with an encapsulation shell; and the assembly to be subjected to heat dissipation is provided with a second connecting component 5 for being connected with the encapsulation shell.

The second connecting component of the assembly to be subjected to heat dissipation can be connected with the encapsulation shell of the electronic device, so that the assembly to be subjected to heat dissipation is mounted on the encapsulation shell of the electronic device. The first connecting component 4 of the heat dissipation component can be connected with the encapsulation shell of the electronic device, so that the heat dissipation component is mounted on the encapsulation shell. Moreover, a TEC cooling component is firmly sandwiched between the heat dissipation component and the assembly to be subjected to heat dissipation by a clamping force generated between the heat dissipation component and the assembly to be subjected to heat dissipation, thereby improving the fixing stability and reliability of the TEC cooling component.

In specific applications, the first connecting component 4 and the second connecting component 5 may each include at least one screw hole, and a corresponding screw hole is also arranged on the encapsulation shell, so that the heat dissipation component, the assembly to be subjected to heat dissipation and the encapsulation shell can be quickly assembled and disassembled through bolts.

Further, a side of the first heat dissipation component 3 away from the TEC 1 is also provided with a second heat dissipation component.

Through the second heat dissipation component, the assembly to be subjected to heat dissipation and the TEC 1 can be subjected to heat dissipation, so that the heat dissipation efficiency of the assembly to be subjected to heat dissipation and the TEC 1 is higher and the heat dissipation effect is better.

Specifically, the second heat dissipation component includes heat dissipation tubes and/or heat dissipation fins 7.

The heat dissipation tubes have low thermal resistance and very high thermal conductivity, and thus can achieve the purpose of rapid heat dissipation. The heat dissipation fins 7 have the advantages of large heat dissipation area, light weight, fast convection and good heat dissipation effect. According to the internal space and arrangement of the electronic device, an operator may use only the heat dissipation tubes or the heat dissipation fins 7, or use the heat dissipation tubes and the heat dissipation fins 7 in combination.

In some implementations, the assembly to be subjected to heat dissipation includes a light source back plate 6, light sources of the projection device are mounted on one side of the light source back plate 6 and the other side of the light source back plate 6 is attached to the cold surface of the TEC 1.

The light sources of the projection device include a plurality of projection lamps, and the number of the projection lamps may be set by the operator voluntarily according to projection requirements. The surface of the light source back plate 6 attached to the TEC 1 needs to have higher flatness, so that the light source back plate 6 is attached to the cold surface of the TEC 1 more closely, and further the heat dissipation effect is better.

Further, the first heat dissipation component 3 and the light source back plate 6 are both metal plates.

The metal plate has better thermal conductivity and can improve the heat dissipation efficiency. In some implementations, the metal plate is a copper plate, and the copper plate has both higher thermal conductivity and excellent corrosion resistance, and can prolong service lives of the first heat dissipation component 3 and the light source back plate 6.

Further, a portion of the light source back plate 6 in contact with air is provided with a heat insulation layer, and the heat insulation layer is used for reducing the heat transferred from the outside hot air to the light source back plate 6.

The heat insulation layer may also be formed by curing the heat insulation sealant. The heat insulation sealant may be an adhesive with low thermal conductivity (such as silica gel or a UV adhesive). The heat insulation layer can play a role of heat insulation, so that the heat transferred from the outside hot air to the light source back plate 6 is reduced, thereby greatly reducing the amount of condensed water generated when the outside hot air meets the low-temperature cold surface, and then avoiding the damage to the electronic elements (such as the light sources) on the light source back plate 6 and the surrounding elements thereof caused by moisture due to a large amount of condensed water.

Further, the light sources include a plurality of projection lamps, the colors of light emitted by at least two of all the projection lamps are different, and a TEC heatsink is arranged nearby the projection lamp emitting the light of a preset color.

In specific applications, the operator may choose the projection lamps that can emit relevant colors voluntarily according to the projection requirements. For example, the light sources of the projection device include a red lamp that can emit red light, a green lamp that can emit green light and a blue lamp that can emit blue light.

The preset color may be determined by the operator voluntarily according to the actual situation, which is not strictly limited by the present disclosure. In specific applications, the heat generated by the projection lamps emitting the light of different colors is also different, and the heat generated by the red lamp emitting red light is usually higher. In this way, the operator may determine red color as the preset color, and thus arrange the TEC heatsink nearby the red lamp.

The TEC heatsink is arranged nearby the projection lamp emitting the light of a preset color, and the projection lamp emitting the light of a preset color can be rapidly cooled by the TEC heatsink, thereby precisely maintaining the projection lamp with a stable temperature range and further ensuring that the projection lamp can stably work to improve the projection effect.

In a second aspect, an embodiment of the present disclosure provides a projection device, including an encapsulation shell, and the encapsulation shell is provided with an assembly to be subjected to heat dissipation and the above heat dissipation assembly.

It should be noted that the heat dissipation assembly involved in the embodiment may adopt the heat dissipation assembly of the above embodiments, and the specific implementation and working principle of the heat dissipation assembly may refer to the corresponding content in the above embodiments, and will not be repeated here.

The present disclosure has been illustrated by the above embodiments, but it should be understood that the above embodiments are only for the purpose of exemplification and illustration, and are not intended to limit the present disclosure to the scope of the described embodiments. In addition, it can be understood by those skilled in the art that the present disclosure is not limited to the above embodiments, more variations and modifications can be made according to the teaching of the present disclosure, and these variations and modifications all fall within the scope claimed by the present disclosure. The protection scope of the present disclosure is defined by the appended claims and the equivalent scope thereof.

## Claims

1. A heat dissipation assembly, comprising a thermal electronic cooler, TEC, and a first heat dissipation component;
wherein an end of the TEC comprises a cold surface, and the other end of the TEC comprises a hot surface; the hot surface of the TEC is attached to the first heat dissipation component, and the cold surface of the TEC is attached to an assembly to be subjected to heat dissipation; and wherein a heat-insulation sealing layer is arranged on an edge of the cold surface of the TEC to seal and thermally insulate the end of the TEC comprising the cold surface.

2. The heat dissipation assembly according to claim 1, wherein the heat-insulation sealing layer comprises a heat-insulation sealing ring formed by heat insulation sealant, and the heat-insulation sealing ring is used seal and thermally insulate the end of the TEC comprising the cold surface.

3. The heat dissipation assembly according to claim 1 or 2, wherein at least part of a surface of the assembly to be subjected to heat dissipation, attached to the cold surface of the TEC, is provided with a heat insulation layer.

4. The heat dissipation assembly according to any one of claims 1 to 3, wherein a first heat-conduction layer is arranged between the hot surface of the TEC and the first heat dissipation component.

5. The heat dissipation assembly according to any one of claims 1 to 4, wherein a second heat-conduction layer is arranged between the cold surface of the TEC and the assembly to be subjected to heat dissipation.

6. The heat dissipation assembly according to any one of claims 1 to 5, wherein the first heat dissipation component is provided with a first connecting component for being connected with an encapsulation shell; and the assembly to be subjected to heat dissipation is provided with a second connecting component for being connected with the encapsulation shell.

7. The heat dissipation assembly according to any one of claims 1 to 6, wherein a side of the first heat dissipation component away from the TEC is further provided with a second heat dissipation component.

8. The heat dissipation assembly according to claim 7, wherein the second heat dissipation component comprises heat dissipation tubes and/or heat dissipation fins.

9. The heat dissipation assembly according to any one of claims 1 to 8, wherein the assembly to be subjected to heat dissipation comprises a light source back plate, light sources of a projection device are mounted on a side of the light source back plate, and the other side of the light source back plate is attached to the cold surface of the TEC.

10. The heat dissipation assembly according to claim 9, wherein the first heat dissipation component and the light source back plate are both metal plates.

11. The heat dissipation assembly according to claim 10, wherein a portion of the light source back plate in contact with air is provided with a heat insulation layer, and the heat insulation layer is used for reducing heat transferred from outside hot air to the light source back plate.

12. The heat dissipation assembly according to claim 9, wherein the light sources comprise a plurality of projection lamps, at least two light sources of all the projection lamps emit light of different colors, and a TEC heatsink is arranged nearby a projection lamp emitting light of a preset color.

13. A projection device, comprising an encapsulation shell, wherein the encapsulation shell is provided with an assembly to be subjected to heat dissipation and the heat dissipation assembly according to any one of claims 1 to 12.
